# DEMANDE DE BREVET EUROPEEN

(11) **EP 1 739 738 A2**
(43) Date de publication de la demande: **03.01.2007**
(21) Numéro de dépôt: 06116315.0
(22) Date de dépôt: 29.06.2006
(51) Int. Cl.: H01L 21/8242, H01L 27/108, H01L 29/78

(54) **Cellule mémoire à un transistor MOS à corps isolé à effet mémoire renforcé**

(30) Priorité: 30.06.2005 FR 0551836
(71) Demandeur: STMicroelectronics ( Crolles 2) SAS, 38920 Crolles (FR)
(72) Inventeur: Ranica, Rossella, 38000, GRENOBLE (FR); Villaret, Alexandre, 38000, GRENOBLE (FR); Mazoyer, Pascale, 38420, DOMENE (FR)
(74) Mandataire: de Beaumont, Michel

(57) **Abrégé**

L'invention concerne une cellule mémoire à un transistor sur région de corps flottant (1) isolée par sa face inférieure par une jonction. Selon l'invention cette jonction est non plane et comporte par exemple une protubérance (40) dirigée vers la surface du transistor.

## Description

### Domaine de l'invention

La présente invention concerne des cellules mémoire de type DRAM à un transistor formé dans un caisson ou corps flottant délimité dans le sens de la profondeur par une jonction. Exposé de l'art antérieur

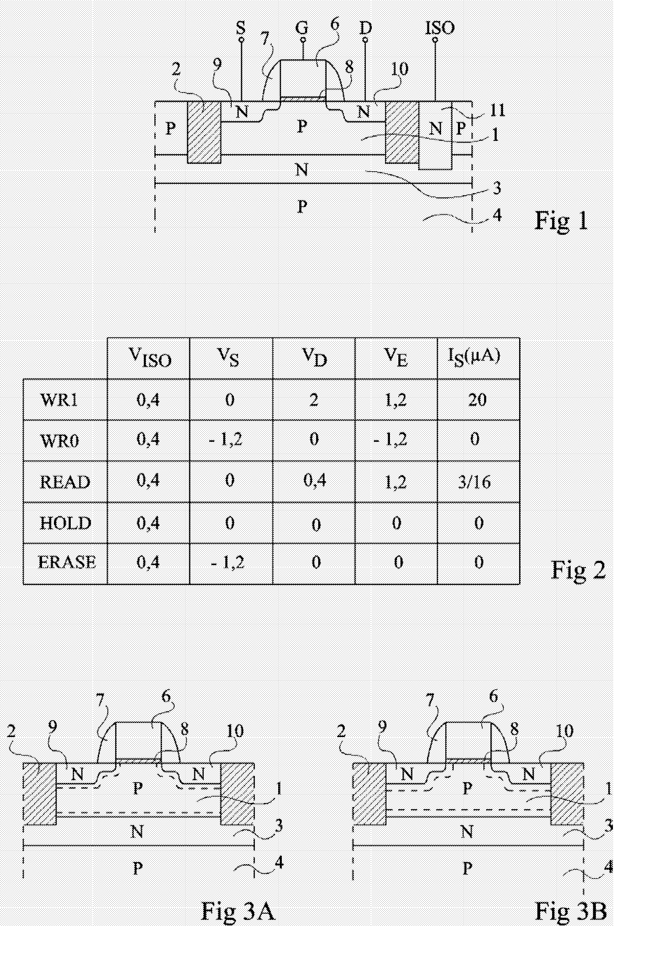

La figure 1 est une vue en coupe schématique d'un exemple d'une telle cellule mémoire. Cette cellule comprend un transistor MOS à canal N formé dans une région de corps flottant 1 délimitée latéralement par un anneau isolant 2 et, dans le sens de la profondeur, par une couche 3 de type N formée dans un substrat 4 de type P. Le transistor MOS comprend, de part et d'autre d'une région de grille 6 entourée d'espaceurs 7 et reposant sur un isolant de grille 8, des régions de source et de drain 9 et 10 de type N. Chacune des régions de source et de drain comprend une région plus dopée et plus profonde à l'extérieur de la région définie par les espaceurs 7 et une région moins dopée et moins profonde sous les espaceurs 7.

En l'absence d'action spécifique sur la cellule, le corps flottant 1 est à un potentiel donné correspondant à l'équilibre thermodynamique. Il a été montré que l'on pouvait injecter dans ce corps des charges positives ou négatives, mettant la cellule dans l'un ou l'autre de deux états déterminés que l'on appellera 1 et 0. En fonction de cette polarisation du substrat, la tension de seuil du transistor se modifie et l'on peut donc distinguer les états 1 et 0.

En outre, la figure 1 représente un puits conducteur 11 de type N rejoignant la couche enterrée 3 pour permettre de la polariser. Dans la figure, la borne de polarisation est appelée ISO, la couche enterrée 3 pouvant être appelée couche d'isolement.

La figure 2 est un tableau illustrant les tensions à appliquer à la cellule dans divers modes de fonctionnement de celle-ci. On a plus particulièrement indiqué les tensions VISO à appliquer sur la couche enterrée 3, VS à appliquer sur la source, VD à appliquer sur le drain, et VG à appliquer sur la grille. Dans la colonne de droite on a indiqué le courant de conduction du transistor mesuré dans ces divers états, désigné par IS et exprimé en microampères alors que toutes les tensions sont exprimées en volts. Plus particulièrement, on a distingué des états d'écriture d'un 1 (WR1), d'écriture d'un 0 (WR0), de lecture (READ), de maintien ou rétention (HOLD), et d'effacement (ERASE). Les valeurs données dans ce tableau le sont uniquement à titre d'exemple et correspondent à une technologie particulière. On retiendra essentiellement les valeurs relatives des diverses tensions et leurs polarités. L'exemple donné correspond à une technologie dans laquelle la dimension minimum possible d'un motif est de l'ordre de 0, 12 µm, dans laquelle on a choisi une longueur de grille de l'ordre de 0,30 µm et une profondeur des régions d'isolement STI 2 de l'ordre de 0,35 µm ainsi qu'une épaisseur d'oxyde de grille de l'ordre de 6 nm.

Ainsi, les principaux états de la cellule sont les suivants.
- Ecriture d'un 1 (WR1). Le transistor MOS est mis dans un état de conduction relativement fort (courant de l'ordre de 20 µA). Cet état peut être établi pendant seulement une très brève durée, par exemple de l'ordre de quelques nanosecondes. A la fin de cet état, quand toutes les tensions appliquées sont ramenées à zéro, sauf la tension de couche enterrée qui est maintenue de préférence à une valeur faiblement positive par exemple 0,4 volt, la cellule mémoire est dans l'état illustré en figure 3A, à savoir que des charges positives se sont accumulées dans le corps flottant. Une fois la cellule mémoire à l'état d'équilibre thermodynamique, ces charges tendent, comme cela est illustré, à rétrécir les zones de charge d'espace. Le transistor a alors une tension de seuil faible, c'est-à-dire que, si l'on se met dans un état de lecture dans lequel le transistor est faiblement polarisé à l'état passant, on observera pour une tension de grille donnée un premier courant (16 µA dans l'exemple illustré).
- Ecriture d'un 0 (WR0). Le transistor est bloqué, sa grille étant mise à un potentiel négatif, et sa source (ou son drain) est également mis à un potentiel négatif, d'où il résulte que les charges positives éventuellement présentes dans le substrat sont éliminées et que des charges négatives sont injectées par suite de la mise à l'état passant de la diode corps-source ou corps-drain. A la fin de cet état, de la façon illustrée en figure 3B, les zones de charge d'espace ont tendance à s'élargir et ceci entraîne que la tension de seuil du transistor augmente. Ainsi, si l'on se met dans des conditions de lecture dans lesquelles le transistor est faiblement polarisé à l'état passant, on obtient pour une même tension de grille de 1,2 V que celle considérée dans le cas précédent, un courant plus faible que le courant à l'état 1 (3 pA au lieu de 16 pA dans l'exemple illustré).
- Lecture (READ). Le transistor MOS est mis dans un état faiblement passant, le drain étant par exemple seulement à une tension de l'ordre de 0,4 V pour limiter les injections susceptibles de déprogrammer le transistor. Le courant traversant le transistor MOS est mesuré ou, de préférence, comparé à une valeur de référence comprise entre les valeurs de courant correspondant aux états 1 et 0.
- Maintien (HOLD). Aucune tension n'est appliquée au transistor. La tension appliquée à la couche enterrée 3 est de préférence maintenue légèrement positive pour mieux bloquer la jonction entre le corps isolé et cette couche enterrée dans le cas où le transistor est programmé à l'état 1.
- Effacement (ERASE). La jonction source/corps (ou drain/corps) est polarisée dans le sens passant ce qui permet l'évacuation des charges positives. La couche enterrée 3 reste faiblement polarisée positivement.

Ainsi, comme on l'a exposé précédemment, l'effet mémoire d'une cellule selon la présente invention se caractérise par une différence entre un courant à l'état 1 et un courant à l'état 0 pour une polarisation drain-source donnée et pour une tension de grille donnée.

### Résumé de l'invention

Un objet de la présente invention est d'améliorer cet effet mémoire.

Pour atteindre cet objet, la présente invention prévoit des structures particulières de cellules mémoire à un transistor à corps isolé par jonction.

Plus particulièrement, la présente invention prévoit une cellule mémoire à un transistor sur région de corps flottant isolée par sa face inférieure par une jonction, dans laquelle ladite jonction est non plane.

Selon un mode de réalisation de la présente invention, ladite jonction comprend une protubérance dirigée vers la surface du transistor.

Selon un mode de réalisation de la présente invention, ladite protubérance fait saillie en direction de la grille sensiblement sous la région de grille du transistor. Cette protubérance peut résulter d'une implantation réalisée avec un masque sensiblement complémentaire du masque de grille.

Selon un mode de réalisation de la présente invention, la cellule mémoire est isolée latéralement par des tranchées comprenant une partie supérieure ayant une largeur correspondant à la largeur normale des tranchées dans la technologie de fabrication choisie et une partie inférieure moins large sensiblement centrée sur la partie supérieure, ladite jonction présentant une protubérance périphérique vers le haut au niveau de la partie inférieure de la tranchée. Cette cellule mémoire peut être obtenue en formant des premières ouvertures peu profondes et en revêtant leurs parois latérales d'espaceurs, en réalisant des secondes ouvertures plus profondes en utilisant lesdits espaceurs comme masque, en remplissant les ouvertures, et en réalisant une implantation partiellement masquée par la partie supérieure des ouvertures remplies.

La présente invention vise aussi un circuit intégré contenant une cellule mémoire telle que susmentionnée.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles:
la figure 1 représente une cellule mémoire à un transistor sur corps flottant ;
la figure 2 est un tableau illustrant des exemples de tensions appliquées à la cellule de la figure 1 dans différents états ;
la figure 3A représente la structure de la figure 1 dans l'état de maintien après écriture d'un état 1 ;
la figure 3B représente la structure de la figure 1 dans l'état de maintien après écriture d'un état 0 ;
la figure 4 est une vue en coupe d'une cellule selon un mode de réalisation de la présente invention ;
les figures 5A à 5D représentent des exemples d'étapes de fabrication de la cellule de la figure 4 ;
la figure 6 représente une cellule mémoire selon un deuxième mode de réalisation de la présente invention ; et
les figures 7A à 7D représentent des exemples d'étapes de fabrication de la structure de la figure 6.

Comme cela est habituel dans la représentation des circuits intégrés, les diverses vues en coupe ne sont pas tracées à l'échelle.

### Description détaillée

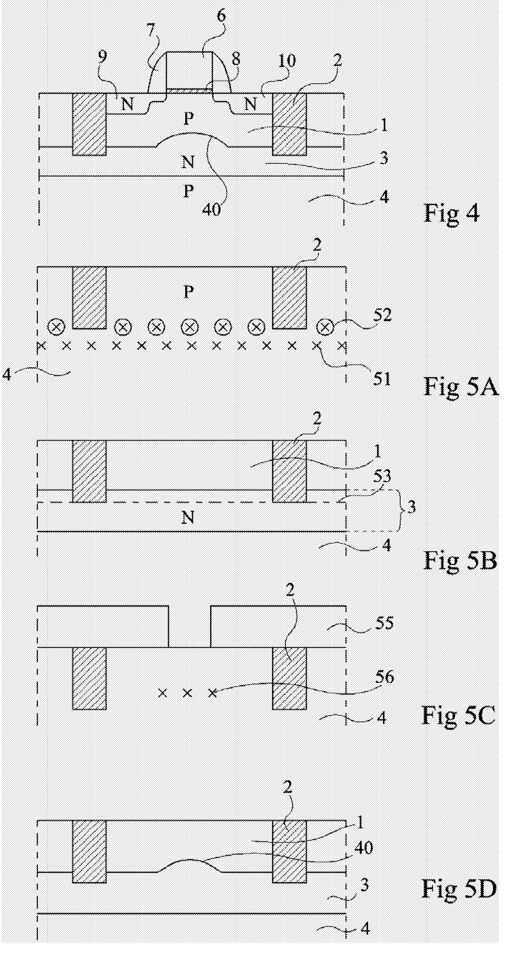

La figure 4 représente, en coupe schématique, un exemple de cellule mémoire à un transistor sur caisson flottant selon un mode de réalisation de la présente invention. Dans cette figure, de mêmes éléments qu'en figure 1 sont désignés par les mêmes références. Dans cette vue en coupe, on n'a pas représenté de zone conductrice permettant d'établir un contact avec la couche enterrée 3, ce contact étant en dehors du plan de la figure ou étant commun à un bloc de cellules.

Dans ce mode de réalisation de la présente invention, la surface de jonction entre le caisson flottant 1 et la couche enterrée 3 est non plane. Elle présente une protubérance 40 sensiblement sous la zone de grille du transistor MOS. Ceci conduit à une augmentation de la surface de jonction par rapport au cas de l'art antérieur illustré en figure 1 où cette jonction est plane.

Les inventeurs ont montré qu'une telle augmentation de la surface de jonction entre la région de corps flottant et la couche enterrée conduisait à une augmentation du potentiel du corps flottant après l'écriture d'un 1 et à une diminution de ce potentiel après l'écriture d'un 0, et donc à une augmentation de la différence entre le potentiel du corps flottant à l'état 1 et son potentiel à l'état 0 ; c'est-à-dire que l'on a une augmentation de l'amplitude de l'effet mémoire de la cellule. Cette augmentation se traduit par une nette augmentation du rapport entre le courant lu après écriture d'un 1 et du courant lu après écriture d'un 0.

Cette augmentation est d'autant plus importante que la protubérance se trouve sous la région de grille. En effet, comme on l'a vu précédemment, en relation avec les figures 3A et 3B, des charges sont stockées au niveau de la jonction considérée et le rapprochement entre ces charges et la zone de jonction conduit à une variation plus importante de la tension de seuil du transistor entre l'état 1 et l'état 0.

Dans le cas où l'épaisseur totale de la région de corps 2 entre sa jonction avec la couche enterrée 3 et la surface supérieure est de l'ordre de 300 nm, la protubérance pourra avoir une hauteur de l'ordre de 100 nm. Ces dimensions sont données dans le cadre de l'exemple précédent correspondant aux valeurs de tension indiquées dans le tableau de la figure 2. La différence entre les courants de lecture d'un état 1 et d'un état 0 est alors augmentée d'environ 30 %.

Les figures 5A à 5D illustrent des étapes successives de fabrication d'un exemple de réalisation de la cellule mémoire de la figure 4.

La figure 5A est une vue en coupe d'une portion d'un substrat de silicium 4 de type P comprenant une zone active délimitée par une tranchée 2 remplie d'un isolant, couramment de l'oxyde de silicium. Pour former la couche enterrée, on procède à une implantation à haute énergie de dopants de type N, tels que du phosphore ou de l'arsenic. Cette implantation peut être réalisée en deux temps. On implante des dopants 51 à haute énergie traversant sensiblement indifféremment le silicium et l'isolant remplissant les tranchées 2. On implante également des dopants 52 de même type de conductivité N, éventuellement identiques aux dopants 51, avec une énergie un peu plus faible telle qu'ils ne traversent pas les régions isolantes 2. Ceci permet de mieux ajuster les dopages. Eventuellement, les dopants 51 et 52 sont implantés à travers des masques différents.

On obtient ainsi la structure illustrée en figure 5B comportant la couche enterrée 3 ayant une surface de jonction sensiblement plane avec la région de corps 1. On a représenté en figure 5B la limite approximative 53 entre la région dopée résultant des dopants 51 et celle résultant des dopants 52, mais, en pratique, ces régions s'interpénètrent.

La figure 5C illustre une étape d'implantation réalisée selon la présente invention. Dans cette étape, on forme sur la structure un masque 55 ayant par exemple une forme sensiblement complémentaire de celle du masque qui sera utilisé ultérieurement pour définir la grille 6 du transistor MOS. A travers ce masque, on procède à une implantation de dopants 56 à une énergie inférieure à celles décrites précédemment pour implanter les dopants 51 et 52. Les dopants 56 se trouvent localisés sensiblement au centre du corps du transistor MOS, sensiblement sous la grille.

On obtient ainsi la structure de la figure 5D dans laquelle la couche implantée 3 comprend une protubérance 40 sensiblement sous la grille du transistor MOS.

Les diverses étapes d'implantation illustrées en figures 5A et 5C peuvent être réalisées dans un ordre quelconque, la forme finale illustrée schématiquement en figure 5D résultant de l'ensemble des recuits réalisés lors de la fabrication complète d'un circuit intégré contenant la cellule représentée.

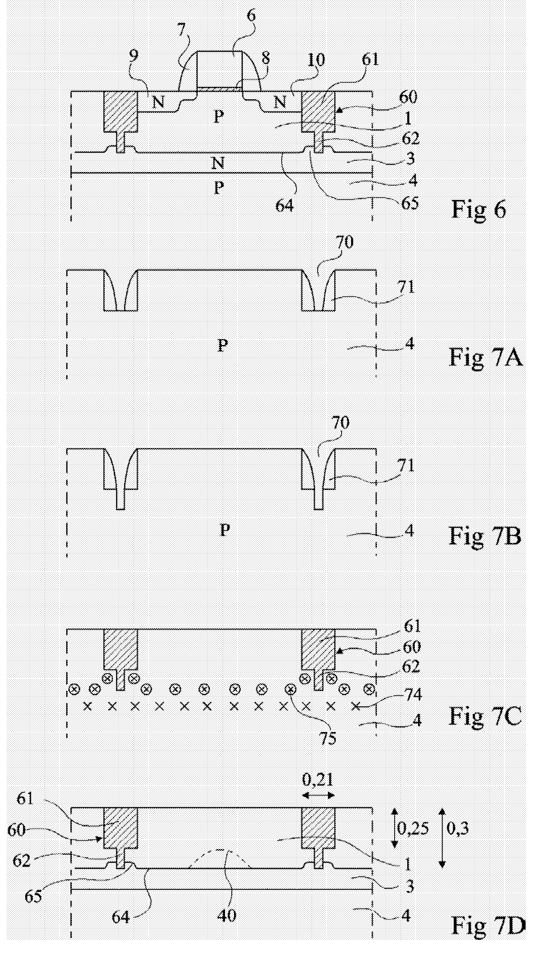

La figure 6 représente un deuxième mode de réalisation de la présente invention dans lequel la jonction 64 entre le corps flottant 1 et la couche enterrée 3 est élargie par sélection d'une forme particulière des tranchées isolantes entourant les zones actives dans lesquelles sont formés les transistors MOS. Comme l'illustre la figure 6, les tranchées 60 comprennent une partie supérieure 61 ayant une profondeur nettement inférieure à la profondeur des tranchées 2 décrites précédemment. La partie supérieure de la tranchée 61, qui a par ailleurs la largeur minimale possible dans la technologie considérée, comme c'était le cas pour les tranchées décrites précédemment en relation avec les figures 1 et 4, est prolongée par une tranchée nettement plus étroite 62 constituant la partie inférieure de la tranchée 60. La profondeur totale de la tranchée 61-62 est du même ordre de grandeur que la profondeur totale des tranchées 2 décrites précédemment. La profondeur de la partie supérieure 61 est supérieure à la profondeur de jonction des régions de drain et de source 9 et 10 mais inférieure à la profondeur de la jonction entre la région de corps flottant 1 et la couche enterrée 3.

La figure 6 illustre l'allure de la jonction 64 entre le corps flottant 1 et la couche enterrée 3 quand une implantation est réalisée après formation des tranchées remplies d'isolant 61 et 62. Cette allure résulte du fait qu'un isolant tel que de l'oxyde freine davantage une implantation que du silicium. Cette jonction 64 est non plane et présente une remontée latérale 65. Cela permet d'augmenter la surface de jonction et donc la possibilité de stockage de charges. (On notera que, en figure 6, pas plus que dans les figures précédentes et suivantes, on ne s'est soucié de la forme de la jonction entre la couche enterrée 3 et le substrat 4, cette forme n'ayant pas d'incidence sur le fonctionnement des cellules mémoire considérées ici).

L'homme de l'art saura optimiser la remontée périphérique 65 de la jonction 64 pour obtenir une augmentation importante de la surface de la jonction.

Les figures 7A à 7D illustrent des étapes d'un exemple de réalisation de la structure de la figure 6.

Comme l'illustre la figure 7A, on part d'un substrat 4 de type P dans lequel on forme des ouvertures 70 correspondant à la périphérie d'une zone active. Les parois des ouvertures 70 sont revêtues d'un espaceur 71 de toute façon connue. Cet espaceur est de préférence en un matériau isolant ou comprend au moins dans sa partie en contact avec la paroi de la tranchée un matériau isolant.

A l'étape suivante illustrée en figure 7B, on regrave le fond de la tranchée par une gravure anisotrope délimitée par les espaceurs 71, un masque non représenté protégeant les zones actives entre les ouvertures 70.

A l'étape illustrée en figure 7C, les tranchées sont remplies d'un matériau isolant ou, comme on l'a indiqué précédemment, les parois des tranchées sont revêtues de matériaux isolants ou oxydées et les tranchées sont remplies d'un matériau non isolant tel que du silicium polycristallin si cela est plus simple dans la technologie de fabrication considérée. On obtient ainsi les tranchées 60 remplies d'un isolant ayant une partie supérieure plus large 61 et une partie inférieure plus étroite 62 telles qu'illustrées en figure 6. On procède alors à deux implantations successives d'un dopant de type N (le même dopant ou des dopants différents), le ou les premiers dopants 74 étant implantés à une énergie suffisante pour pénétrer sous le fond des tranchées et le deuxième dopant 75 étant implanté sensiblement au niveau du fond de la partie supérieure 61 de la tranchée 60 et étant masqué par le débordement latéral de la partie supérieure 61 de la tranchée par rapport à la partie inférieure 62.

Ainsi, après recuit, on obtient une structure du type de celle illustrée en figure 7D, correspondant à la structure de la figure 6.

On a désigné par un trait en pointillés 40 une protubérance centrale pour bien préciser que les modes de réalisation décrits en relation avec les figures 4 et 6 peuvent être combinés.

Bien que l'on ait décrit précédemment deux modes de réalisation particulièrement avantageux de la présente invention, on notera que la présente invention vise de façon générale la formation d'une jonction non plane entre la région de corps d'une cellule mémoire à un transistor MOS sur corps isolé et que diverses autres variantes peuvent être envisagées pour obtenir ce résultat qui présente l'avantage d'augmenter l'effet mémoire d'une cellule du type considéré.

La présente invention est susceptible de diverses variantes et modifications qui apparaîtront à l'homme de l'art. Notamment, les divers matériaux utilisés et les dimensions indiquées pourront être modifiés selon la technologie utilisée, du moment que les fonctions décrites sont atteintes. En outre, bien que l'on ait décrit ici un transistor MOS à canal N, la cellule mémoire pourra comprendre un transistor MOS à canal P, les types de conductivité et les polarités des charges étant modifiés en conséquence.

## Revendications

1. Cellule mémoire à un transistor sur région de corps flottant isolée par sa face inférieure par une jonction, **caractérisée en ce que** ladite jonction est non plane.

2. Cellule mémoire selon la revendication 1, dans laquelle ladite jonction comprend une protubérance (40) dirigée vers la surface du transistor.

3. Cellule mémoire selon la revendication 2, dans laquelle ladite protubérance (40) fait saillie en direction de la grille sensiblement sous la région de grille du transistor.

4. Procédé de fabrication d'une cellule mémoire selon la revendication 3, dans lequel ladite protubérance résulte d'une implantation réalisée avec un masque sensiblement complémentaire du masque de grille.

5. Cellule mémoire selon la revendication 1, isolée latéralement par des tranchées (60) comprenant une partie supérieure (61) ayant une largeur correspondant à la largeur normale des tranchées dans la technologie de fabrication choisie et une partie inférieure (62) moins large sensiblement centrée sur la partie supérieure, dans laquelle ladite jonction présente une protubérance périphérique vers le haut au niveau de la partie inférieure de la tranchée.

6. Procédé de fabrication d'une cellule mémoire selon la revendication 5, comprenant les étapes suivantes :
former des premières ouvertures peu profondes (70) et revêtir leurs parois latérales d'espaceurs,
réaliser des secondes ouvertures plus profondes (71) en utilisant lesdits espaceurs comme masque,
remplir les ouvertures, et
réaliser une implantation partiellement masquée par la partie supérieure des ouvertures remplies.

7. Circuit intégré contenant une cellule mémoire selon la revendication 1.
